# EUROPEAN PATENT SPECIFICATION

(11) **EP 0 552 023 B1**
(45) Date of publication and mention of the grant of the patent: **02.04.1997**
(21) Application number: 93300196.8
(22) Date of filing: 13.01.1993
(51) Int. Cl.: H01L 33/00, H01L 21/441

(54) **Electrode structure for semiconductor device**
Elektroden-Struktur für Halbleiteranordnung
Structure d'électrode pour dispositif semi-conducteur

(30) Priority: 14.01.1992 JP 5168/92
(43) Date of publication of application: 21.07.1993
(73) Proprietor: Mitsubishi Chemical Corporation, Chiyoda-ku Tokyo (JP)
(72) Inventor: Goto, Hideki, Tsuchiura, Ibaraki (JP)
(74) Representative: Paget, Hugh Charles Edward

(56) References cited:
- US-A- 4 123 295
- PATENT ABSTRACTS OF JAPAN, vol. 13, no. 393 (E-814) 31 August 1989 ; & JP-A-11 40 663
- SOLAR CELLS, vol. 27, no. 1-4, October 1989, Lausanne CH, pp. 177-189; M.-A. NICOLET et al.: 'Issues in metal/semiconductor contact design and implementation'
- JOURNAL OF PHYSICS D : APPLIED PHYSICS, vol. 16, 1983, Letchworth GB, pp. 2333-2340; E. JANIK et al.: 'Ohmic contacts to p-type cadmium telluride and cadmium mercury telluride'
- JOURNAL OF CRYSTAL GROWTH, vol. 86, no. 1-4, 1 January 1988, Amsterdam NL, pp. 917-923; J. THOMPSON et al.: 'The growth of CdHgTe by metalorganic chemical vapour deposition for optical communication devices'
- APPLIED PHYSICS LETTERS, vol. 29, no. 7, New York US, 1 October 1976, pp. 433-434; J.S. BEST et al.: 'HgSe, a highly electronegative stable metallic contact for semiconductor devices'

## Description

The present invention relates to a semiconductor device, and in particular to a Group II-VI semiconductor device having a P-type ohmic electrode structure. As is conventional in this field, by Group II we refer to Group IIb

Recently, blue light emitting diodes (LEDs) or blue laser diodes (LDs) have become available, using a plural component Group II-VI semiconductor which is higher than ternary and which contains zinc and selenium. In particular, with the use of a P-N junction which is formed by using nitrogen (N) as a P-type dopant, suitable light emission can be obtained.

However, there are few metals suitable for a P-type ohmic electrode having a low resistance for use with P-type Group II-VI compounds. Accordingly, the P-layer side ohmic resistances of green to blue light emitting diodes or semiconductor lasers having P-N junctions are extremely high, and accordingly, the major part of the power injected into a device such as an LED or LD, is consumed in the form of heat, resulting in low efficiency of light emission with respect to the power injected. Further, the generation of heat possibly causes the devices such as LEDs or LDs to deteriorate, lowering the reliability of the device. Accordingly, the formation of a satisfactory P-type ohmic electrode is indispensable for obtaining practically usable devices such as LEDs or LDs.

JP-A-1-140663 discloses a device having an ohmic contact electrode on a p-ZnSe layer. A p-type amorphous Si layer is grown by CVD on the p-ZnSe layer, and Mo and Al are deposited on the Si. The p-ZnSe and p-Si are said to have near work functions, and Mo is said to make good ohmic contact with the p-Si.

In Applied Physics Letters, 29, No.7, Oct. 1976, pages 433-4 (Best et al.), it is described that HgSe forms Schottky barriers on n-ZnS and n-ZnSe. It is concluded that HgSe is more electronegative than Au, and it is suggested that it should be useful for ohmic contact to p-semiconductors but no test of this is reported.

An object of the present invention is therefore to provide a P-type ohmic electrode having a low electric resistance, for Group II-VI semiconductor elements containing P-type zinc and selenium.

After much study, the present inventor has found that a satisfactory ohmic electrode can be formed using Group IIb elements other than zinc or Group II-VI semiconductors containing, as a constituent element, a Group IIb element other than zinc.

The present invention provides a Group II-VI semiconductor element characterized in that a part on a Group II-VI semiconductor containing P-type zinc and selenium, on which an ohmic metal electrode is formed, is formed of a zinc selenide Group II-VI semiconductor layer containing a Group IIb element other than zinc, or a thin film made of a Group IIb element other than zinc is formed between the surface of a Group II-VI semiconductor containing P-type zinc and selenium, and the ohmic metal electrode.

The present invention also consists in semiconductor devices including such a semiconductor element.

The main feature of the present invention is the provision of an ohmic electrode suitable for a Group II-VI semiconductor. Accordingly, the structure of the semiconductor device, other than the electrode and a layer adjacent to the electrode, can be the same as in known semiconductor devices such as LED, LD or the like, and is not limited.

The layer adjacent to the electrode, that is, the layer on which the electrode is formed, may be made of a Group II-VI compound in the form of a zinc selenide or zinc selenide based plural component P-type semiconductor (which will be hereinbelow denoted simply "zinc selenide layer" for the sake of brevity). The zinc selenide layer has on it a layer in which a Group IIb element other than zinc is diffused into the Group II-VI compound semiconductor. Preferably the density of the Group IIb element other than zinc gradually increases from the zinc selenide layer side to the electrode side. The concentration of the Group IIb element other than zinc at the electrode side is preferably higher than 1% (% by atom), and is more preferably higher than 10%, most preferably higher than 30%. Preferably in particular, the surface of the layer on the electrode side is substantially wholly made of the Group IIb element other than zinc. With this arrangement, the band gap gradually decreases towards the electrode and good ohmic contact with respect to the Group IIb element other than zinc is established. Further, in a particularly preferable configuration, the surface is substantially defined by a layer containing a Group IIb element other than zinc, and accordingly satisfactory ohmic contact with another metal can be attained.

The method of diffusing a Group IIb element other than zinc into zinc selenide is not limited to any specific one, and any suitable conventional method can be used. Suitable methods are one in which the Group IIb element other than zinc is diffused by heat treatment into the zinc selenide layer from a layer made of the Group IIb element other than zinc formed on the zinc selenide layer, and another in which the partial pressure of the Group IIb element other than zinc in gas is changed during vapour phase growth (deposition from vapour phase).

Particularly preferred is the method in which the Group IIb element other than zinc is diffused by heat treatment from a layer thereof formed on the zinc selenide layer. With this method, the structure in which the concentration of the Group IIb element other than zinc gradually increases from the zinc selenide layer side to the electrode side can be readily obtained. By the method in which the partial pressure of the Group IIb element other than zinc in gas is changed in vapour phase growth, the content of the Group IIb element other than zinc in the zinc selenide is continuously changed so that the density thereof can be changed in the form of a linear function when graphically shown, or the content of the Group IIb element other than zinc in the zinc selenide is intermittently changed so that the density thereof can be varied in a stepped manner when graphically shown.

In another embodiment, the same effect of reduced resistance can be obtained by means of a layer of a Group IIb element, for example mercury, between the p-type semiconductor containing Zn and Se.

However, for example, mercury which can be used as the Group IIb element other than zinc on the surface or as a thin layer and which has a liquid phase at room temperature, is readily evaporated and is soon lost. This fact not only causes problems in normal use but also causes serious problems when using heat treatment for diffusing the Group IIb element into zinc selenide. In a method by which the above mentioned problems can be solved, a high melting point metal layer having a more or less high mechanical strength is formed on the layer containing, as a main component, the Group IIb element other than zinc, in order to restrain the Group IIb element other than zinc from evaporating. Specifically, metal having a high melting point of higher than 2000°C such as platinum or tungsten can be used as the high melting point metal. Since a metal wire or the like is difficult to bond directly to platinum, tungsten or the like as mentioned above, a layer of lower melting point metal, e.g. a gold layer, is preferably formed on the above-mentioned high melting point metal layer.

Embodiments of the invention will now be described by way of example with reference to the accompanying diagrammatic drawings, in which:-
Fig. 1 is an explanatory view illustrating a structure of an ohmic electrode which is an essential part of a first semiconductor device embodying the present invention;
Fig. 2 is an explanatory view illustrating one example of the structure of the P-type ohmic electrode of a semiconductor device according to the present invention;
Fig. 3 is an explanatory view illustrating another example of the structure of a semiconductor device according to the present invention; and
Fig. 4 is an explanatory view illustrating a further example of the structure of a semiconductor device according to the present invention.

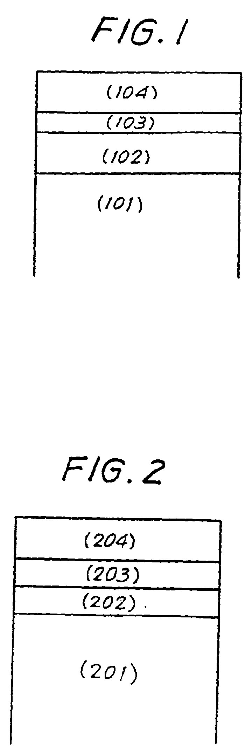

In Fig. 1, there are shown a P-type ZnSe layer 101, a ZnSe layer 102 diffused with Hg and having a thickness of about 10 nm to 1µm, a Pt layer 103 having a thickness of about 50 nm to 500 nm and an Au layer 104 having a thickness of about 100 nm to 2µm.

By this structure, according to the present invention, an ohmic electrode having a good bonding ability can be readily formed on a Group II-VI semiconductor device containing a P-type ZnSe layer.

Explanation has been hereinabove made of a method of diffusing the Group II elements other than zinc using heat treatment. Next, explanation will be made of another method of making a structure of the invention in which a Group II-VI compound containing, as a constituent element, a Group IIb element other than zinc is formed by crystal growth on a given P-type Group II-VI compound before an ohmic electrode is formed. Such Group II-VI compounds containing a Group II element other than zinc include HgSe (or another Se containing compound excepting zinc selenide), HgTe (or another Te containing compound excepting zinc telluride). Also in this case, an ohmic electrode can be readily formed for the reason mentioned above. An example of this structure of the invention is shown in Fig. 2 in which there is a P-type ZnSe layer 201, a P-type HgSe semiconductor layer 202 having a thickness of 10 to 100 nm, an HgTe layer 203 having a thickness of abut 10 to 100 nm, and an Au electrode having a thickness of about 100 nm to 2µm. Naturally, a structure in which ZnSe is gradually changed into HgSe over the HgSe layer thickness, that is to say the substitution x of ZnₓHg₁₋ₓSe is changed to 0 from 1, is also effective. Similarly, the substitution y of HgSe_{y}Te_{1-y} in the HgTe layer may change gradually to 0 from 1, and this is also effective.

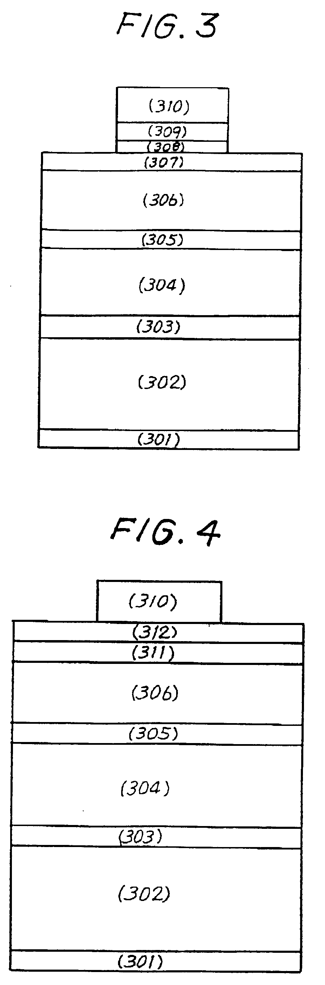

Fig. 3 shows a more specific embodiment which is an LED, but the present invention is not limited thereby.

Referring to Fig. 3, an n-type ZnSe layer 303 doped with Cl (chlorine) and having a thickness of 0.2µm (carrier density of 1 x 10¹⁸ cm⁻³), an n-type ZnS_{0.07}Se_{0.93} layer 304 having a thickness of 1µm (carrier density of 1 x 10¹⁷ cm⁻³), a P-type Cd_{0.2}Zn_{0.8}Se layer 305 doped with N (nitrogen) and having a thickness of 0.1µm (carrier density x 10¹⁷ cm⁻³), a P-type ZnSe_{0.07}S_{0.93} layer 306 similarly doped with N (carrier density of 3 x 10¹⁷ cm⁻³) and finally a P-type ZnSe layer 307 doped with N and having a thickness of 0.2µm were grown successively on an N-type GaAs substrate 302 by a MBE (molecular beam epitaxy) process at a growth temperature of 300°C. Thereafter, an In layer 301 as an n-type electrode was deposited by evaporation on the n-type GaAs substrate side, and an Hg layer 308 having a thickness of 30 nm, a Pt layer 309 having a thickness of 100 nm and an Au layer 310 having a thickness of 500 nm were deposited by evaporation on a P-type electrode side, and the device was heat-treated for 10 minutes in the atmosphere of nitrogen at a temperature of 280°C. Hg is still present as a thin layer after this heat treatment. This LED was energized by applying a voltage thereto in a forward direction. The value of current fed to the LED was 20 mA. In this mode, a comparative structure in which Au alone is used for the P-type electrode on the ZnSe layer 307 required 15 V as an operational voltage. In contrast, the structure of this embodiment required 3.3 V from which it can be seen that great improvement can be achieved.

In the embodiment shown in Fig. 4, a P-type HgSe layer 311 doped with N and having a thickness of 50 nm and a HgTe layer 312 having a thickness of a 50 nm were formed by crystal growth by an MBE process on the crystal growth structure of layers 303-307 obtained by the MBE process on the substrate 302 in the embodiment of Fig, 3, and then an In layer 301 as an n-type n-type electrode was deposited by evaporation on the GaAs substrate side, and an Au layer 310 having a thickness of 500 nm as a P-type electrode was deposited by evaporation for 10 minutes in an atmosphere of nitrogen at a temperature of 20°C. Thereafter, a current of 20 mA was fed to the LED in the forward direction so as to energize it, as in the embodiment of Fig. 3. The average operational voltage was about 3.2 V.

According to the present invention, a satisfactory P-type ohmic electrode suitable for Group II-VI semiconductor devices can be obtained, and in particular, a satisfactory semiconductor device such as a blue LED or the like can be obtained.

## Claims

1. A P-type electrode structure of a Group II-VI semiconductor device having a P-type Group II-VI semiconductor layer (101;201;301) consisting of or containing Zn and Se, an ohmic metal electrode (104;204;310), and at least one intermediate layer (102;202,203;311,312) between said semiconductor layer (101;201;301) and said electrode (104;204;310), characterised in that said at least one intermediate layer (102;202,203;311,312) consists of a Group II-VI compound containing a Group IIb element other than Zn.

2. An electrode structure according to claim 1 wherein said intermediate layer is a Group II-VI semiconductor layer (102) consisting of or including Zn and Se having said Group IIb element other than Zn diffused into it.

3. An electrode structure according to claim 1 or claim 2 having a layer (308) of said Group IIb element other than Zn between said P-type semiconductor layer (301) and said electrode (310).

4. An electrode structure according to claim 2 having a metal layer (103;309) of melting point of more than 2000°C between said intermediate layer (102) and said electrode (310).

5. An electrode structure according to claim 3 having a metal layer (103;309) of melting point of more than 2000°C between said layer (308) of said Group IIb element other than Zn and said electrode (310).

6. An electrode structure according to claim 1 wherein the or each said intermediate layer is a semiconductor layer (202,203;311,312) of a binary Group II-VI compound wherein the Group IIb element is other than Zn or a ternary Group II-VI compound containing Zn and a Group IIb compound other than Zn.

7. An electrode structure according to any one of claims 1 to 6 wherein said intermediate layer (102;202,203;311,312) has a concentration of said Group IIb element other than Zn which increases in the direction towards said electrode (310).

8. An electrode structure according to any one of claims 1 to 7 wherein said Group IIb element other than Zn is Hg.

9. A P-type electrode structure of a Group II-VI semiconductor device having a P-type Group II-VI semiconductor layer (301) consisting of or containing Zn and Se, an ohmic metal electrode (310), and a layer (308) between said semiconductor layer (301) and said electrode (310), characterized in that said layer (308) consists of a Group IIb element other than Zn.

10. An electrode structure according to claim 9 wherein there is a metal layer (309) of melting point of more than 2000°C between said layer (308) of a Group IIb element other than Zn and said electrode (310).

11. An electrode structure according to claim 9 or claim 10 wherein said Group IIb element other than Zn is Hg.

12. A Group II-VI semiconductor device having a P-type Group II-VI semiconductor layer (101;201;301) and an electrode structure therefor according to any one of claims 1 to 11.

13. A Group II-VI semiconductor light emitting diode having a P-type Group II-VI semiconductor layer (101;201;301) and an electrode structure therefor according to any one of claims 1 to 11.

## Patentansprüche

1. Elektrodenstruktur vom p-Typ einer II-VI-Gruppen-Halbleitervorrichtung bzw. -anordnung, umfassend eine Schicht eines II-VI-Gruppen-Halbleiters vom p-Typ (101; 201; 301), die aus Zn und Se besteht oder diese enthält, eine ohm'sche Metallelektrode (104; 204; 310) und zumindest eine Zwischenschicht (102; 202, 203; 311, 312) zwischen der Halbleiterschicht (101; 201; 301) und der Elektrode (104; 204; 310), dadurch gekennzeichnet, daß zumindest eine Zwischenschicht (102; 202, 203; 311, 312) aus einer II-VI-Gruppen-Verbindung besteht, die ein IIb-Gruppen-Element außer Zn enthält.

2. Elektrodenstruktur nach Anspruch 1, worin die Zwischenschicht eine II-VI-Gruppen-Halbleiterschicht (102) ist, die aus Zn und Se besteht oder diese enthält und das IIb-Gruppen-Element außer Zn darin eindiffundiert aufweist.

3. Elektrodenstruktur nach Anspruch 1 oder 2, die eine Schicht (308) aus dem IIb-Gruppen-Element außer Zn zwischen der Halbleiterschicht vom p-Typ (301) und der Elektrode (310) aufweist.

4. Elektrodenstruktur nach Anspruch 2, die eine Metallschicht (103; 309) mit einem Schmelzpunkt von mehr als 2.000°C zwischen der Zwischenschicht (102) und der Elektrode (310) aufweist.

5. Elektrodenstruktur nach Anspruch 3, die eine Metallschicht (103; 309) mit einem Schmelzpunkt von mehr als 2.000°C zwischen der Schicht (308) aus dem IIb-Gruppen-Element außer Zn und der Elektrode (310) aufweist.

6. Elektrodenstruktur nach Anspruch 1, worin die oder jede Zwischenschicht eine Halbleiterschicht (202,203;311,312) aus einer binären II-VI-Gruppen-Verbindung, worin das IIb-Gruppen-Element ein anderes als Zn ist, oder aus einer ternären II-VI-Gruppen-Verbindung, die Zn und eine andere IIb-Gruppen-Verbindung als Zn enthält.

7. Elektrodenstruktur nach einem der Ansprüche 1 bis 6, worin die Zwischenschicht (102; 202, 203; 311, 312) eine Konzentration des IIb-Gruppen-Elements außer Zn aufweist, die in Richtung zur Elektrode (310) hin zunimmt.

8. Elektrodenstruktur nach einem der Ansprüche 1 bis 7, worin das IIb-Gruppen-Element außer Zn Hg ist.

9. Elektrodenstruktur vom p-Typ einer II-VI-Gruppen-Halbleitervorrichtung bzw. -anordnung, umfassend eine Schicht eines II-VI-Gruppen-Halbleiters vom p-Typ (301), die aus Zn und Se besteht oder diese enthält, eine ohm'schen Metallelektrode (310) und eine Schicht (308) zwischen der Halbleiterschicht (301) und der Elektrode (310), dadurch gekennzeichnet, daß die Schicht (308) aus einem anderen IIb-Gruppen-Element als Zn besteht.

10. Elektrodenstruktur nach Anspruch 9, worin sich eine Metallschicht (309) mit einem Schmelzpunkt von über 2.000°C zwischen der Schicht (308) aus einem IIb-Gruppen-Element außer Zn und der Elektrode (310) befindet.

11. Elektrodenstruktur nach Anspruch 9 oder 10, worin das IIb-Gruppen-Element außer Zn Hg ist.

12. II-VI-Gruppen-Halbleitervorrichtung bzw. -anordnung, die eine Schicht eines II-VI-Gruppen-Halbleiters vom p-Typ (101; 201; 301) und eine Elektrodenstruktur dafür nach einem der Ansprüche 1 bis 11 aufweist.

13. II-VI-Gruppen-Halbleiter-Lumineszenz- bzw. -Leucht-Diode bzw. -LED bzw. lichtemittierende II-VI-Gruppen-Halbleiter-Diode, die eine Schicht eines II-VI-Gruppen-Halbleiters vom p-Typ (101; 201; 301) und eine Elektrodenstruktur dafür nach einem der Ansprüche 1 bis 11 aufweist.

## Revendications

1. Structure d'électrode du type P d'un dispositif à semi-conducteur du groupe II-VI ayant une couche semi-conductrice (101; 201; 301) du groupe II-VI du type P consistant en Zn et Se ou contenant du Zn et Se, une électrode métallique ohmique (104; 204; 310) et au moins une couche intermédiaire (102; 202, 203; 311, 312) entre ladite couche semi-conductrice (101; 201; 301) et ladite électrode (104; 204; 310), caractérisée en ce que ladite au moins couche intermédiaire (102; 202, 203; 311, 312) consiste en un composé du groupe II-VI contenant un élément du groupe IIb autre que Zn.

2. Structure d'électrode selon la revendication 1 dans laquelle la couche intermédiaire précitée est une couche semi-conductrice (102) du groupe II-VI consistant en Zn et Se ou contenant du Zn et Se ayant l'élément du groupe IIb autre que Zn diffusé dans celle-ci.

3. Structure d'électrode selon la revendication 1 ou la revendication 2 ayant une couche (308) de l'élément précité du groupe IIb autre que Zn entre la couche semi-conductrice précitée (301) du type P et l'électrode précitée (310).

4. Structure d'électrode selon la revendication 2 ayant une couche métallique (103; 309) de point de fusion de plus que 2000°C entre la couche intermédiaire précitée (102) et l'électrode précitée (310).

5. Structure d'électrode selon la revendication 3 ayant une couche métallique (103;309) de plus que 2000°C entre la couche précitée (308) de l'élément du groupe IIb précité autre Zn et l'électrode précitée (310).

6. Structure d'électrode selon la revendication 1 dans laquelle la ou chaque couche intermédiaire précitée est une couche semi-conductrice (202, 203; 311, 312) d'un composé binaire du groupe II-VI où l'élement du groupe IIb est autre que Zn où un composé ternaire du groupe II-VI contenant Zn d'un composé du groupe IIb autre que Zn.

7. Structure d'électrode selon l'une quelconque des revendications 1 à 6 dans laquelle la couche intermédiaire précitée (102; 202, 203; 311, 312) a une concentration de l'élément du groupe IIb précité autre que Zn qui augmente dans la direction vers l'électrode précitée (310).

8. Structure d'électrode selon l'une quelconque des revendications 1 à 7 dans laquelle l'élément du groupe IIb précité autre que Zn est Hg.

9. Structure d'électrode du type P d'un dispositif à semi-conducteur du groupe II-VI ayant une couche semi-conductrice (301) du groupe II-VI du type P consistant en Zn et Se ou contenant du Zn et Se, une électrode métallique ohmique (310) et une couche (308) entre ladite couche semi-conductrice (301) et ladite électrode (310), caractérisée en ce que ladite couche (308) est un élément du groupe IIb autre que Zn.

10. Structure d'électrode selon la revendication 9 dans laquelle il y a une couche métallique (309) de point de fusion de plus que 2000°C entre la couche précitée (308) d'un élément du groupe IIb autre que Zn et l'électrode précitée (310).

11. Structure d'électrode selon la revendication 9 ou la revendication 10 dans laquelle l'élément du groupe IIb précité autre que Zn est Hg.

12. Dispositif à semi-conducteur du groupe II-VI ayant une couche semi-conductrice (101; 201; 301) du groupe II-VI du type P et une structure d'électrode pour celui-ci selon l'une quelconque des revendications 1 à 11.

13. Diode à émission de lumière semi-conductrice du groupe II-VI ayant une couche semi-conductrice (101; 201; 301) du groupe II-VI du type P et une structure d'électrode pour celle-ci selon l'une quelconque des revendications 1 à 11.
